# EUROPÄISCHE PATENTSCHRIFT

(11) **EP 3 365 745 B1**
(45) Veröffentlichungstag und Bekanntmachung des Hinweises auf die Patenterteilung: **24.06.2020**
(21) Anmeldenummer: 16785479.3
(22) Anmeldetag: 24.10.2016
(51) Int. Cl.: G05G 1/02

(54) **BEDIENEINHEIT FÜR EINE FAHRZEUGKOMPONENTE, INSBESONDERE FÜR EINE HEIZUNGS-, LÜFTUNGS- UND/ODER KLIMAANLAGE**
CONTROL UNIT FOR A VEHICLE COMPONENT, IN PARTICULAR FOR A HEATING, VENTILATION AND/OR AIR CONDITIONING SYSTEM
UNITÉ DE COMMANDE D'UN COMPOSANT D'UN VÉHICULE, EN PARTICULIER D'UN SYSTÈME DE CHAUFFAGE, VENTILATION ET/OU CLIMATISATION

(30) Priorität: 23.10.2015 DE 102015220789
(43) Veröffentlichungstag der Anmeldung: 29.08.2018
(73) Patentinhaber: Behr-Hella Thermocontrol GmbH, 70469 Stuttgart (DE)
(72) Erfinder: FUST, Winfried, 59556 Lippstadt (DE)
(74) Vertreter: dompatent von Kreisler Selting Werner - Partnerschaft von Patent- und Rechtsanwälten mbB
(86) Internationale Anmeldenummer: PCT/EP2016/075565
(87) Internationale Veröffentlichungsnummer: WO 2017/068189

(56) Entgegenhaltungen:
- EP-A1- 2 372 915
- DE-A1-102008 019 124
- DE-A1-102011 082 143
- DE-U1- 9 010 425
- US-A1- 2015 054 756

## Beschreibung

Die Erfindung betrifft eine Bedieneinheit für eine Fahrzeugkomponente, wobei es sich bei der Fahrzeugkomponente insbesondere um eine Heizungs-, Lüftungs- und/oder Klimaanlage handelt. Grundsätzlich lässt sich die Bedieneinheit aber auch zur Steuerung anderer Fahrzeugkomponenten verwenden wir z.B. einem Radio einem Infotainment-Gerät und/oder einem Navigationsgerät.

Bedieneinheiten für Fahrzeugkomponenten sind in den unterschiedlichsten Ausgestaltungen bekannt. In den letzten Jahren setzen sich mehr und mehr Bedieneinheiten durch, bei denen eine akustische oder taktile Rückmeldung erfolgt, wenn ein Betätigungselement der Bedieneinheit manuell betätigt wird. Im Regelfall handelt es sich bei dem Betätigungselement um ein Bauteil, das berührungssensitiv ist und mehrere Symbolfelder zur Eingabe unterschiedlichster Befehle aufweist.

Das Konzept der haptischen Rückmeldung bei erkannter Betätigung einer Bedieneinheit wird auch als "Force Sense, Force Feedback" bezeichnet. Dabei soll das im Regelfall niederdrückbare Betätigungselement nur einen möglichst geringen Hub ausführen müssen, um die Berührung eines Symbolfeldes mit dem Ziel der Auslösung der entsprechenden Bedienfunktion zur quittieren. Dabei ist aus Komfortgründen gewünscht, dass sich das gesamte Betätigungselement parallel verschiebt, und zwar auch dann, wenn das Betätigungselement beispielsweise am Rand, also möglichst weit entfernt vom Schwerpunkt des Betätigungselements bzw. Mittelpunkt seiner Bedienfläche manuell niedergedrückt wird.

Im Stand der Technik sind Parallelführungen an Bedientasten sowie Bedienelementen mit mehrere Symbolfelder aufweisenden Bedienflächen bekannt. Dabei werden zum Teil Blattfederkonstruktionen verwendet, die allerdings immer größer werdenden Komfortansprüchen nur eingeschränkt gerecht werden könnten.

DE-A-10 2011 082 143 offenbart eine Bedieneinheit mit einem manuell betätigbaren Betätigungselement und einer Lagervorrichtung zur elastischen Lagerung des Betätigungselements. Die Lagervorrichtung weist zwei Blattfederpaare mit zwei übereinander verlaufenden Blattfedern, wobei die Enden der Blattfedern durch ein Abstandselement starr miteinander verbunden sind.

Aus DE-A-10 2008 019 124 ist es bekannt, Balancierungselemente in zwei unterschiedlichen axialen Richtungen anzuordnen, um die Aufgabe des Nicht-Wippens zu lösen.

Aus DE-A-10 2014 007 988 ist ein reversibel niederdrückbarer Taster bekannt, der zu beiden Seiten eines zu der Bedienfläche orthogonal und in Bewegungsrichtung verlaufenden Steg gelenkig mit Hebelpaaren verbunden ist, wobei die einen Hebelpaare ihrerseits gelenkig an Festlagern befestigt sind und die gegenüberliegenden Hebelpaare gelenkig an Gleitlagern befestigt sind.

Aus DE-A-36 16 669 ist eine Einzelfederbalkenanordnung an den vier Randabschnitten eines Halteelements beschrieben, wobei durch die vier Einzelfederbalken ein Rahmen federnd gelagert ist der ein Tastenelement trägt.

Weitere Tastenführungen sind aus DE-A-197 57 928 und DE-A-37 11 789 bekannt.

Aufgabe der Erfindung ist es, die Parallelführung von niederdrückbaren Bedienelementen, insbesondere solchen mit mehrere Symbolfelder aufweisenden Bedienflächen, zu verbessern. Zur Lösung dieser Aufgabe wird mit der Erfindung eine Bedieneinheit für eine Fahrzeugkomponente, insbesondere für eine Heizungs-, Lüftungs- und/oder Klimaanlage, vorgeschlagen, wobei die Bedieneinheit versehen ist mit
- einem manuell betätigbaren Betätigungselement (10),
- einer Haltevorrichtung (16) zur Halterung des Betätigungselements (10) und
- einer Lagervorrichtung (18) zur elastischen Lagerung des Betätigungselements (10) an der Haltevorrichtung (16),
- wobei die Lagervorrichtung (18) mindestens ein erstes Blattfederpaar (64) mit zwei übereinander sowie zueinander beabstandet angeordneten und parallel zueinander verlaufenden Blattfedern (36) mit jeweils einem ersten Ende und einem diesen gegenüberliegenden zweiten Ende aufweist, wobei die ersten und die zweiten Enden der Blattfedern (36) jeweils durch ein Abstandselement (40) starr miteinander verbunden sind und wobei das mindestens eine erste Blattfederpaar (64) an den ersten Enden seiner Blattfedern (36) mit dem Betätigungselement (10) und an den zweiten Enden seiner Blattfedern (36) mit der Haltevorrichtung (16) direkt oder indirekt starr verbunden sind,
- wobei die Lagervorrichtung (18) zwischen dem Betätigungselement (10) und der Haltevorrichtung (16) mindestens zwei erste und mindestens zwei zweite Blattfederpaare (64,66) aufweist,
- wobei die ersten Blattfederpaare (64) untereinander parallel zueinander und die zweiten Blattfederpaare (66) untereinander parallel zueinander angeordnet sind und
- wobei die ersten Blattfederpaare (64) im Wesentlichen orthogonal zu den zweiten Blattfederpaaren (66) ausgerichtet sind.

Bei der Erfindung ist das mindestens eine manuell betätigbare Betätigungselement der Bedieneinheit elastisch an einer Haltevorrichtung gelagert. Hierzu dient eine Lagervorrichtung, die zwischen dem Betätigungselement und der Haltevorrichtung angeordnet ist. Diese Lagervorrichtung weist mindestens ein Blattfederpaar auf. Dieses erste Blattfederpaar umfasst zwei parallel zueinander verlaufende, übereinanderliegende und beabstandete Blattfedern, deren Enden über Abstandselemente auf Abstand gehalten sind. Das eine Paar von Blattfederenden ist an dem Betätigungselement und das andere Paar von Blattfederenden ist an der Haltevorrichtung direkt bzw. indirekt fixiert. Eine derartige elastische Blattfederlagerung führt zu einer Parallelverschiebung des Betätigungselements, wenn dies niedergedrückt wird, wobei die Elastizität der zwischen ihren Enden eingespannten Blattfedern ausgenutzt wird. Dies gilt strenggenommen nur für vergleichsweise kurze Hübe von einigen wenigen Millimetern bzw. einigen wenigen 1/10 mm. Entscheidend ist, dass die Bewegungsrichtung des Betätigungselements beim Niederdrücken im Wesentlichen orthogonal zur Bedienfläche des Betätigungselements verläuft und diese ihre Ausrichtung im Raum dabei nicht verändert (Parallelführung).

Um nun die Parallelführung und die orthogonal zur Bedienfläche verlaufende Bewegungsrichtung des Betätigungselements im Wesentlichen unabhängig vom Betätigungsort auf der Bedienfläche garantieren zu können, ist nach der Erfindung vorgesehen, dass die Lagervorrichtung neben dem mindestens einen ersten Blattfederpaar mindestens ein zweites Blattfederpaar aufweist, das in einem von 0° verschiedenen Winkel zu dem mindestens einen ersten Blattfederpaar und insbesondere orthogonal zu diesem ausgerichtet ist. Hierdurch wird die Parallelführung des Betätigungselements bei dessen Niederdrücken deutlich verbessert, und zwar unabhängig vom Ort der Einleitung der Niederdruckkraft auf das Betätigungselement. Die Verschiebung der Bedienfläche nach unten erfolgt dabei also unter Parallelführung dieser Bedienfläche. Ein Verkippen ist im Wesentlichen unterdrückt.

Die Erfindung sieht ferner vor, dass die Lagervorrichtung mindestens zwei erste und mindestens zwei zweite Blattfederpaare aufweist, wobei die ersten Blattfederpaare untereinander parallel zueinander und die zweiten Blattfederpaare untereinander parallel zueinander angeordnet sind und wobei die ersten Blattfederpaare im Wesentlichen orthogonal zu den zweiten Blattfederpaaren ausgerichtet sind.

Vorteil der zuvor beschriebenen Parallelführung der Bedienfläche ist, dass die Sensorik, die eine Betätigung, das heißt manuelle Hubbewegung des Betätigungselements erkennt, einfacher ausgeführt sein kann und im Zweifel auch auf eine Verkippung reagieren darf. Da eine derartige Verkippung aber weitestgehend unterdrückt ist, ist diese für Verkippungen sensitive Sensorik insoweit "immun". Im Idealfall bedarf es lediglich noch eines einzigen Weg- bzw. Kraftsensors für das gesamte Betätigungselement. Dies reduziert den Hardwareaufwand der Konstruktion der erfindungsgemäßen Bedieneinheit deutlich.

Im Regelfall sind Bedieneinheiten der hier in Rede stehenden Art mit rechteckartigen Betätigungselementen bzw. mit Betätigungselementen ausgestattet, die eine im Wesentlichen rechteckige Bedienfläche aufweisen. Damit weist das Betätigungselement bzw. seine Bedienfläche vier vorzugsweise im Wesentlichen gradlinige, paarweise gegenüberliegende Randabschnitte auf. Zweckmäßig ist es nun, wenn die Lagervorrichtung zwei erste und zwei zweite Blattfederpaare aufweist, wobei an jedem der vier Randabschnitte jeweils ein Blattfederpaar derart angeordnet ist, dass seine Blattfedern parallel bzw. im Wesentlichen parallel, d.h. in Erstreckung des jeweiligen Randabschnitts verlaufen.

Bei einer weiteren vorteilhaften Ausgestaltung der Erfindung kann vorgesehen sein, dass ein erstes und ein zweites Blattfederpaar als integrales Winkelblattfederpaar mit zwei winkelförmig und insbesondere rechtwinkelförmig verlaufenden Blattfedern ausgebildet sind. Bei dieser Variante sind also jeweils ein erstes und ein zweites Blattfederpaar integral ausgebildet, was den Montageaufwand reduziert. Die jeweils übereinander angeordneten Blattfedern des ersten und des zweiten Paars sind paarweise betrachtet winkelig, insbesondere rechtwinklig zu einander ausgerichtet. Derartige Winkelblattfederpaare können mit Vorteil in zwei diagonal gegenüberliegenden Eckenbereichen eines im Wesentlichen rechteckigen Betätigungselements bzw. Betätigungselements mit im Wesentlichen rechteckiger Bedienfläche angeordnet sein.

Bei der zuvor beschriebenen Ausgestaltung der Erfindung, d.h. bei der Verwendung von Winkelblattfederpaaren, kann es von Vorteil sein, wenn jede Winkelblattfeder zwei Schenkel aufweist, wobei jeder Schenkel ein freies Ende und ein mit dem jeweils anderen Schenkel integral verbundenes Verbindungsende aufweist und wobei entweder die freien Enden der Schenkel mit dem Betätigungselement und die Verbindungsenden der Schenkel mit der Haltevorrichtung oder umgekehrt direkt oder indirekt verbunden sind.

Wie bereits oben erwähnt, sind die Blattfedern jedes Blattfederpaars durch Abstandselemente auf Abstand gehalten. Im Falle der Verwendung von Winkelblattfedern existieren pro Winkelblattfederpaar vorzugsweise drei derartige Abstandselemente, und zwar jeweils ein Abstandselement an den freien Enden der beiden Schenkel der Winkelblattfedern und ein weiteres Abstandselement zwischen den Verbindungsenden der beiden Winkelblattfedern.

In weiterer vorteilhafter Ausgestaltung der Erfindung ist die Bedieneinheit des Weiteren mit einem Aktuator zur Zwangsbewegung des Betätigungselements bei Sensierung einer Mindestbetätigungskraft bzw. eines Mindestbetätigungshubs versehen. Hierbei wird über einen Sensor, der in diesem Fall auch Teil der erfindungsgemäßen Bedieneinheit sein kann, die Mindestkrafteinleitung bzw. der Mindestbewegungshub sensiert und an eine Ansteuer- und Auswerteeinheit weitergegeben. Diese wiederum steuert einen mechanischen Aktuator an, der beispielsweise in Form eines Queranker-Elektromagneten ausgebildet ist. Der Anker wird entweder einmalig angezogen, was zu einer Vergrößerung der Hubbewegung des Betätigungselements oder aber auch zu einer Querbewegung (in eingeschränktem Umfang) führen kann. Mit dem Aktuator lassen sich aber ebenso gut auch Vibrationsbewegungen des Betätigungselements als taktile Rückmeldung der erfolgreichen Betätigung desselben ausführen. Schließlich kann auch noch eine weitere Rückmeldung in beispielsweise akustischer oder optischer Form erfolgen.

Die Erfindung wird nachfolgend anhand zweier Ausführungsbeispiele und der Zeichnung näher erläutert. Im Einzelnen zeigen dabei:
- Fig. 1: eine Draufsicht auf die Bedienfläche eines niederdrückbaren, elastische gelagerten Betätigungselements mit in diesem Ausführungsbeispiel neun Betätigungs- bzw. Bedien-/ Symbolfeldnern,
- Fig. 2: eine perspektivische Ansicht auf die Unterseite des Betätigungselements gemäß Fig. 1,
- Fign. 3 bis 6: Seitenansichten entsprechend den Pfeilen III bis VI der Fig. 2 auf das Betätigungselement mit unterhalb von diesem angeordneten Blattfeder-Lagerungselementen,
- Fig. 7: ein Schnitt durch ein Gehäuse mit in diesem elastisch gelagerten Betätigungselement gemäß Fign. 1 bis 6 im Ausgangszustand, also ohne Krafteinleitung auf das Betätigungselement,
- Fig. 8: eine Schnittansicht ähnlich der gemäß Fig. 7 jedoch bei manueller Betätigung des Betätigungselements, so dass dessen Betätigung durch eine Sensorik erkannt wird,
- Fig. 9: eine Schnittansicht ähnlich der gemäß Fign. 7 und 8 jedoch nach Aktivierung eines Aktuators zur z.B. weiteren Bewegung des Betätigungselements in Niederdrückrichtung als haptische/taktile Rückmeldung des Betätigungselements,
- Fig. 10: eine Unteransicht auf ein Betätigungselement ähnlich dem, wie es in Draufsicht in Fig. 1 gezeigt ist, jedoch mit alternativ ausgebildeten Blattfeder-Lagerelementen und
- Fign. 11 bis 14: Seitenansichten des Betätigungselements in Richtung der Pfeile XI bis XIV gemäß Fig. 10 mit den an den Unterseiten angeordneten Blattfeder-Lagerelementen.

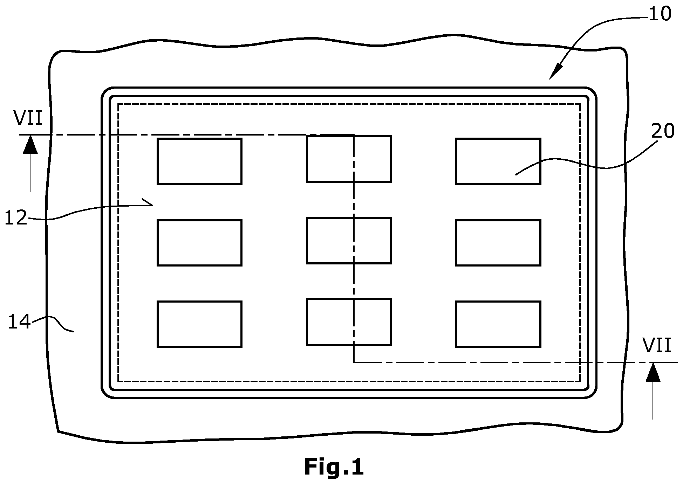

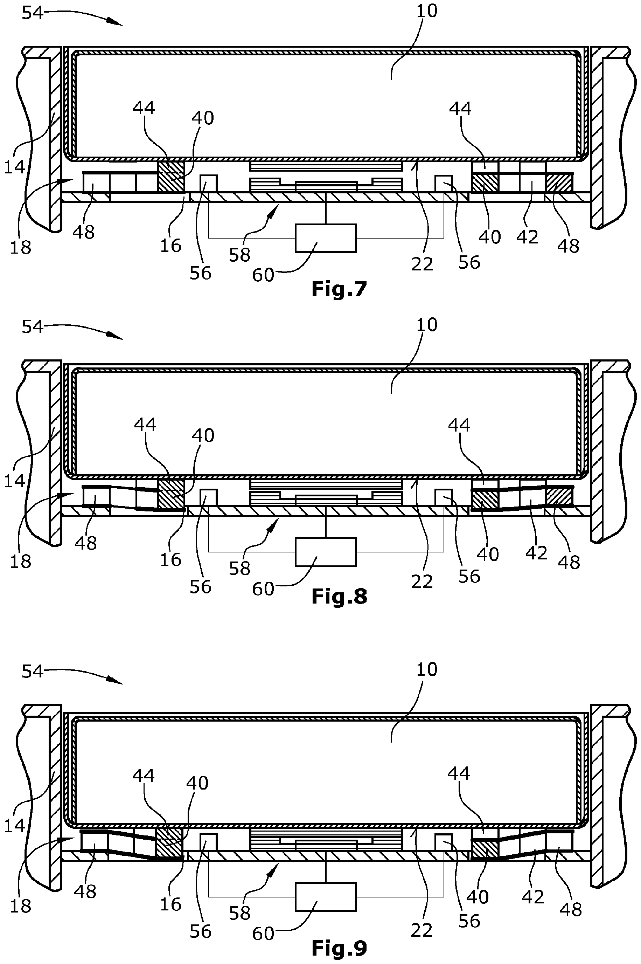

In den Fign. 1 bis 6 ist die Konstruktion und elastische Lagerung eines Betätigungselements 10 mit Bedienfläche 12 gezeigt, die beim Niederdrücken des Betätigungselements 10 ihre Aufrichtung beibehält, also parallel verschoben wird. Dieses Betätigungselement 10 ist, wie in Fig. 7 gezeigt, innerhalb eines Gehäuses 14 verbaut, das eine Haltevorrichtung 16, beispielsweise in Form einer Platine umfasst, an der das Betätigungselement 10 mittels einer Lagervorrichtung 18 elastisch und niederdrückbar gelagert ist.

Gemäß Fig. 1 weist die Bedienfläche 12 mehrere (, im Ausführungsbeispiel neun,) Bedien- bzw. Symbolfelder 20 auf. An der der Bedienfläche 12 abgewandten Unterseite 22 des Betätigungselements 10 ist die Lagervorrichtung 18 angeordnet, die das Betätigungselement 10 elastisch mit der Haltevorrichtung 16 verbindet. Zu diesem Zweck weist die Lagervorrichtung 18 im Ausführungsbeispiel gemäß den Fign. 1 bis 9 zwei Winkelblattfederpaare 24,26 auf, die in zwei diagonal gegenüberliegenden Eckenbereichen 28,30 der Unterseite 22 des Betätigungselements 10 angeordnet sind. Jedes Winkelblattfederpaar 24,26 weist zwei in diesem Ausführungsbeispiel rechtwinklige Blattfedern 32,34 auf, die jeweils zwei Schenkel 36,38 aufweisen. An den freien Enden jedes jeweils parallel übereinanderliegenden Schenkels 36,38 befindet sich ein Abstandselement 40,42, das die jeweiligen Schenkelenden auf Abstand hält und überdies mit der Unterseite 22 des Betätigungselements 10 verbunden ist.

Hierzu sind die Abstandselemente 40,42 jeweils in einem neben den Schenkel 36,38 liegenden Bereich über die jeweils obere Winkelblattfeder 34 hinaus verlängert, so dass sich ein Versatz 44 ergibt.

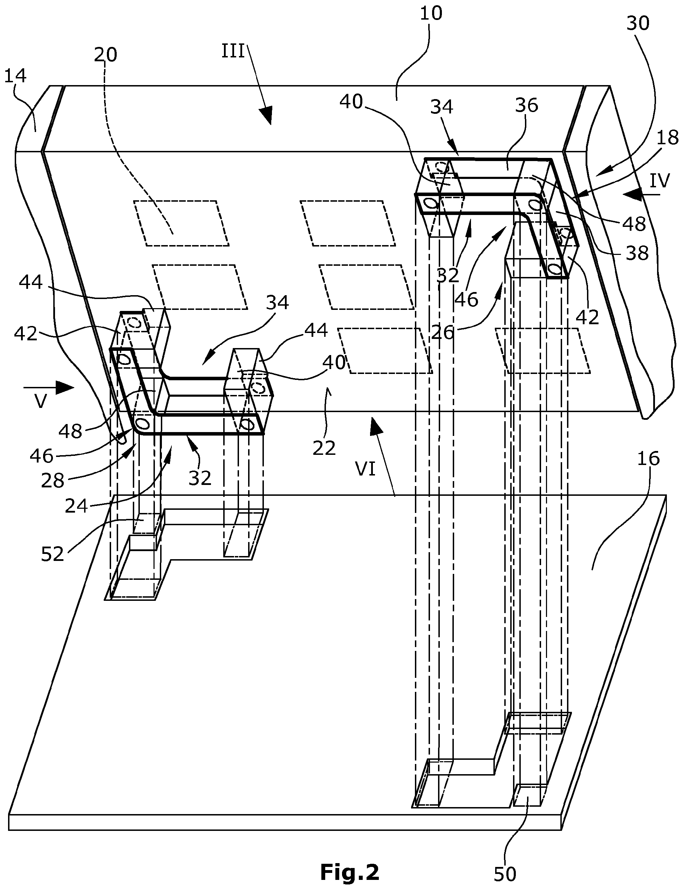

In den Eckenbereichen bzw. an den Verbindungsenden 46 der Schenkelpaare 36,38 der Winkelblattfedern 32,34 befindet sich zwischen diesen ebenfalls ein weiteres Abstandselement 48. Bei 50,52 ist in Fig. 2 angedeutet, dass die Winkelblattfederpaare 24,26 in diesen Eckenbereichen 28,30, d.h. im Bereich der Verbindungsenden 46 an der Haltevorrichtung 16 gelagert sind.

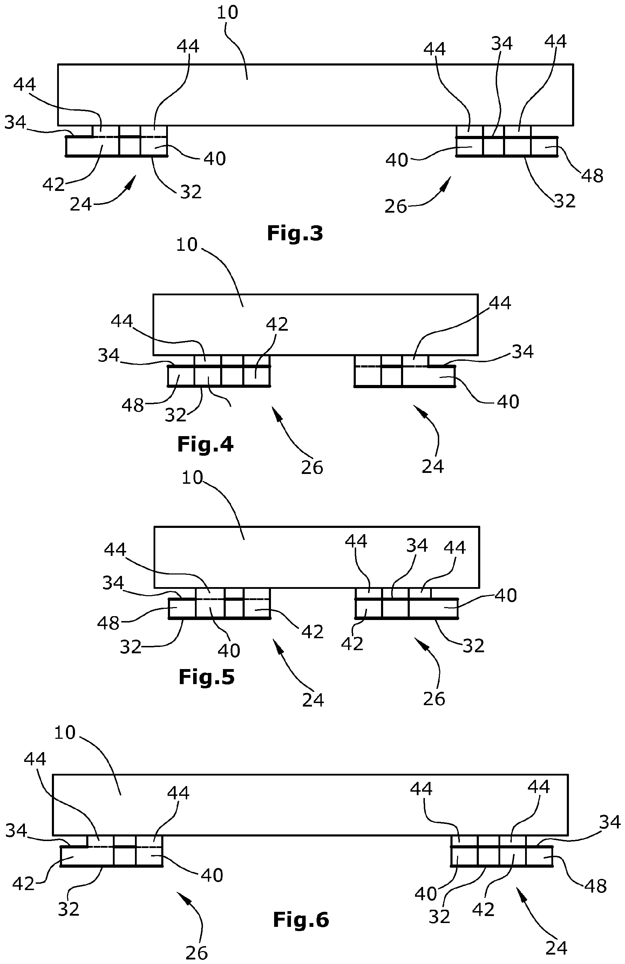

Die Anbindung der Winkelblattfederpaare 24,26 an der Unterseite 22 des Betätigungselements 10 und ihre Lagerung an der Haltevorrichtung 16 sind in den Seitenansichten der Fign. 3 bis 6 deutlicher dargestellt.

In den Fign. 7 bis 9 sind verschiedene Situationen im Zuge der Betätigung des Betätigungselements 10 gezeigt, wenn dieses in einer Bedieneinheit 54 verbaut ist. Die Bedieneinheit 54 weist das Gehäuse 14 und die Haltevorrichtung 16 sowie die Lagervorrichtung 18 auf. Zusätzlich ist die Bedieneinheit noch mit in diesem Ausführungsbeispiel zwei Abstands- bzw. Kraftsensoren 56 versehen, die anhand des bei Betätigung des Betätigungselements 10 von diesem zurückgelegten Wegs erkennen, dass auf das Betätigungselement 10 eine Mindestbetätigungskraft zur gewollten Auslösung einer Funktion aufgebracht ist. Zusätzlich weist die Bedieneinheit 54 einen Aktuator 58 auf, der in diesem Ausführungsbeispiel als Queranker-Elektromagnet ausgebildet ist. Die Sensoren 56 und der Aktuator 58 sind über eine Auswerte- und Ansteuereinheit 60 miteinander verbunden.

Fig. 7 zeigt die Situation bei noch nicht betätigtem Betätigungselement 10 (Ruheposition). In Fig. 8 ist dargestellt, dass beispielsweise an der Position des Krafteinleitungspfeils 62 auf die Bedienfläche 12 eine Betätigungskraft eingeleitet worden ist. Das Betätigungselement 10 wird unter Beibehaltung der Ausrichtung der Bedienfläche 12, also unter Parallelverschiebung dieser Bedienfläche 12, nach unten verschoben. Für die Beibehaltung der Ausrichtung der Bedienfläche 12 sorgen die Winkelblattfederpaare, das heißt die in diesem Ausführungsbeispiel vier Blattfederpaare 64,66, die paarweise parallel zueinander ausgerichtet sind, wobei die beiden parallel zueinander ausgerichteten ersten Blattfederpaare 64 quer zu den zweiten Blattfederpaaren 66 ausgerichtet sind.

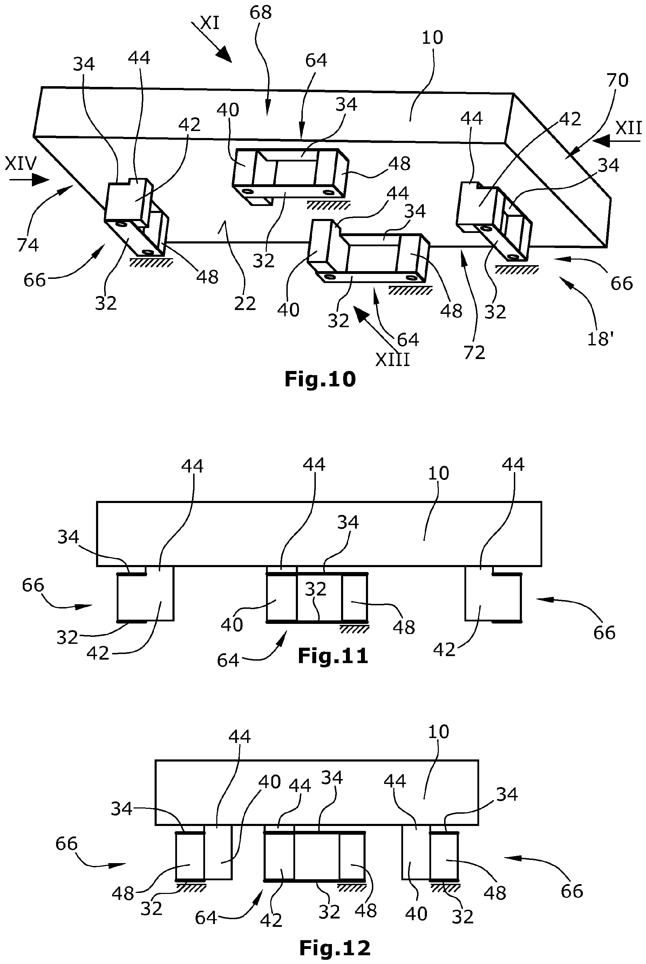

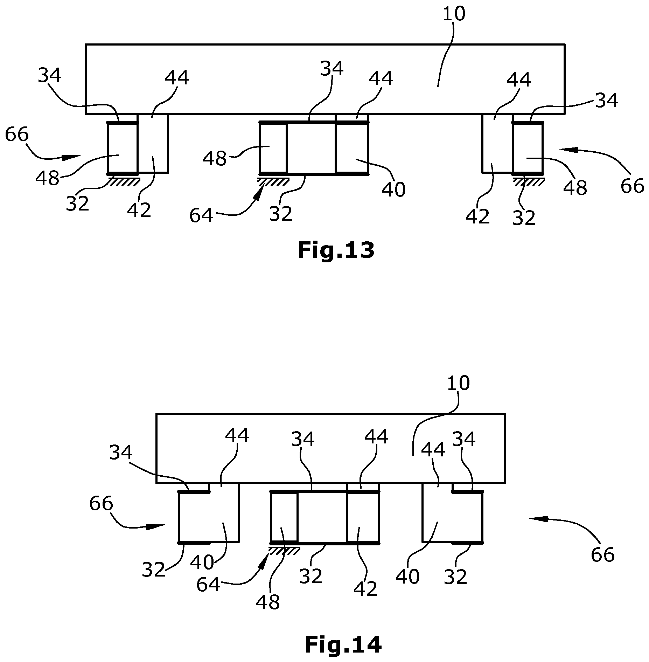

In den Fign. 10 bis 14 ist ein alternatives Ausführungsbeispiel der Lagervorrichtung 18 gemäß dem Ausführungsbeispiel nach den Fign. 1 bis 9 gezeigt. Die entsprechende Lagervorrichtung ist in Fig. 10 mit dem Bezugszeichen 18' gekennzeichnet. Soweit die in den Fign. 10 bis 14 gezeigten Elemente denjenigen des Ausführungsbeispiels gemäß den Fign. 1 bis 9 entsprechen (d.h. baugleich bzw. funktionsgleich sind), sind sie mit dem gleichen Bezugszeichen gekennzeichnet.

Bei dem Ausführungsbeispiel gemäß den Fign. 10 bis 14 existieren vier getrennt voneinander ausgebildete und angeordnete Blattfederpaare 64,66, die jeweils zwei Blattfedern 36 bzw. 38 aufweisen. Die vier Blattfederpaare 64,66 sind auf die vier Randbereiche 68,70,72,74 des Betätigungselements 10, an dessen Unterseite 22 verteilt angeordnet. Bei 50 ist wiederum in den Fign. 10 bis 14 gezeigt, wo die Blattfederpaare an der Haltevorrichtung 16 gelagert sind. Bei 44 ist in diesen Figuren wiederum gezeigt, wo die Blattfederpaare 64,66 an die Unterseite 22 des Betätigungselements 10 angebunden sind.

### BEZUGSZEICHENLISTE

- 10: Betätigungselement
- 12: Bedienfläche des Betätigungselements
- 14: Gehäuse
- 16: Haltevorrichtung
- 18: Lagervorrichtung für das Betätigungselement
- 18': Lagervorrichtung für das Betätigungselement
- 20: Symbolfelder auf der Bedienfläche
- 22: Unterseite des Betätigungselements
- 24: Winkelblattfederpaar
- 26: Winkelblattfederpaar
- 28: Eckenbereich des Betätigungselements
- 30: Eckenbereich des Betätigungselements
- 32: Winkelblattfeder
- 34: Winkelblattfeder
- 36: Schenkel der Winkelblattfeder
- 38: Schenkel der Winkelblattfeder
- 40: Abstandselement der (Winkel-)Blattfederpaare
- 42: Abstandselement der (Winkel-)Blattfederpaare
- 44: Fixierung der Blattfederpaare an dem Bedienelement
- 46: Verbindungsenden der Schenkel
- 48: Abstandselement der (Winkel-)Blattfederpaare
- 50: Verbindung von Winkelblattpaar mit Haltevorrichtung
- 52: Verbindung von Winkelblattpaar mit Haltevorrichtung
- 54: Bedieneinheit
- 56: Kraft- bzw. Wegsensor
- 58: Aktuator
- 60: Auswerte- und Ansteuereinheit
- 62: Krafteinleitungspunkt
- 64: Blattfederpaar
- 66: Blattfederpaar
- 68: Randbereich des Betätigungselements
- 70: Randbereich des Betätigungselements
- 72: Randbereich des Betätigungselements
- 74: Randbereich des Betätigungselements

## Patentansprüche

1. Bedieneinheit für eine Fahrzeugkomponente, insbesondere für eine Heizungs-, Lüftungs- und/oder Klimaanlage, mit
- einem manuell betätigbaren Betätigungselement (10),
- einer Haltevorrichtung (16) zur Halterung des Betätigungselements (10) und
- einer Lagervorrichtung (18) zur elastischen Lagerung des Betätigungselements (10) an der Haltevorrichtung (16),
- wobei die Lagervorrichtung (18) mindestens ein erstes Blattfederpaar (64) mit zwei übereinander sowie zueinander beabstandet angeordneten und parallel zueinander verlaufenden Blattfedern (36) mit jeweils einem ersten Ende und einem diesen gegenüberliegenden zweiten Ende aufweist, wobei die ersten und die zweiten Enden der Blattfedern (36) jeweils durch ein Abstandselement (40) starr miteinander verbunden sind und wobei das mindestens eine erste Blattfederpaar (64) an den ersten Enden seiner Blattfedern (36) mit dem Betätigungselement (10) und an den zweiten Enden seiner Blattfedern (36) mit der Haltevorrichtung (16) direkt oder indirekt starr verbunden sind,
**dadurch gekennzeichnet,**
- **dass** die Lagervorrichtung (18) zwischen dem Betätigungselement (10) und der Haltevorrichtung (16) mindestens zwei erste und mindestens zwei zweite Blattfederpaare (64,66) aufweist,
- **dass** die ersten Blattfederpaare (64) untereinander parallel zueinander und die zweiten Blattfederpaare (66) untereinander parallel zueinander angeordnet sind und
- **dass** die ersten Blattfederpaare (64) im Wesentlichen orthogonal zu den zweiten Blattfederpaaren (66) ausgerichtet sind.

2. Bedieneinheit nach Anspruch 1, **dadurch gekennzeichnet, dass** das Betätigungselement (10) rechteckartig mit vier im Wesentlichen gradlinigen, paarweise gegenüberliegenden Randabschnitten (68,70,72,74) ausgebildet ist und dass mindestens zwei erste und mindestens zwei zweite Blattfederpaare (64,66) längs jeweils einem der vier Ränder des Betätigungselements (10) angeordnet sind.

3. Bedieneinheit nach Anspruch 1 oder 2, **dadurch gekennzeichnet, dass** die beiden jeweils übereinander angeordneten Enden der Blattfedern (36) jedes Blattfederpaars (64, 66) durch die Abstandselemente (40) auf Abstand gehalten sind.

4. Bedieneinheit nach einem der Ansprüche 1 bis 3, **dadurch gekennzeichnet, dass** ein erstes und ein zweites Blattfederpaar (64,66) als integrales Winkelblattfederpaar (24,26) mit zwei winkelförmig und insbesondere rechtwinkelförmig verlaufenden Blattfedern (32,34) ausgebildet sind.

5. Bedieneinheit nach Anspruch 3 oder 4, **dadurch gekennzeichnet, dass** jede Winkelblattfeder (32,34) zwei Schenkel (36,38) aufweist, dass jeder Schenkel (36,38) ein freies Ende und ein mit dem jeweils anderen Schenkel (36,38) integral verbundenes Verbindungsende (46) aufweist und dass entweder die freien Enden der Schenkel (36,38) mit dem Betätigungselement (10) und die Verbindungsenden (46) der Schenkel (36,38) mit der Haltevorrichtung (16) oder umgekehrt direkt oder indirekt verbunden sind.

6. Bedieneinheit nach Anspruch 5, **dadurch gekennzeichnet, dass** die freien Enden der Schenkel (36,38) durch jeweils ein Abstandselement (40) und die Verbindungsenden (46) der Schenkel (36,38) durch ein weiteres Abstandselement (48) auf Abstand gehalten sind.

7. Bedieneinheit nach Anspruch 2 und 4 oder nach einem der vorhergehenden Ansprüche soweit auf die Ansprüche 2 und 4 rückbezogen, **dadurch gekennzeichnet, dass** jeweils ein Winkelblattfederpaar (24, 26) zumindest in jedem von zwei diagonal gegenüberliegenden Eckenbereichen (28, 30) des Betätigungselements (10) angeordnet sind.

## Claims

1. An operating unit for a vehicle component, in particular for a heating, ventilation and/or air conditioning system, comprising:
- a manually actuatable actuating element (10);
- a retaining device (16) for retaining the actuating element (10); and
- a bearing device (18) for elastically mounting the actuating element (10) on the retaining device (16),
- wherein the bearing device (18) comprises at least one first leaf spring pair (64), including two leaf springs (36) that are disposed on top of and spaced apart from one another and extend parallel to one another, each having a first end and a second end located opposite therefrom, wherein the first and second ends of the leaf springs (36) are each rigidly joined to one another by a spacer element (40), and wherein the at least one first leaf spring pair (64), at the first ends of the leaf springs (36) thereof, is directly or indirectly rigidly joined to the actuating element (10), and at the second ends of the leaf springs (36) thereof, is directly or indirectly rigidly joined to the retaining device (16),
**characterized in that**
- the bearing device (18) comprises at least two first and at least two second leaf spring pairs (64, 66) between the actuating element (10) and the retaining device (16),
- the first leaf spring pairs (64) are disposed parallel among one another and the second leaf spring pairs (66) are disposed parallel among one another, and
- the first leaf spring pairs (64) are substantially oriented orthogonally the second leaf spring pairs (66).

2. The operating unit according to claim 1, **characterized in that** the actuating element (10) is designed in a rectangular manner, including four edge sections (68, 70, 72, 74) that are substantially rectilinear and located opposite one another in pairs, and at least two first and at least two second leaf spring pairs (64, 66) are disposed along each of the four edges of the actuating element (10).

3. The operating unit according to claim 1 or 2, **characterized in that** the two ends of the leaf springs (36) of each leaf spring pair (64, 66), which are disposed on top of one another, are held at a distance by the spacer elements (40).

4. The operating unit according to any one of claims 1 to 3, **characterized in that** a first and a second leaf spring pair (64, 66) are designed as an integral angular leaf spring pair (24, 26) comprising two leaf springs (32, 34) that extend at an angle, and in particular at a right angle.

5. The operating unit according to claim 3 or 4, **characterized in that** each angular leaf spring (32, 34) includes two legs (36, 38), each leg (36, 38) has a free end and a connecting end (46) integrally joined to the respective other leg (36, 38), and either the free ends of the legs (36, 38) are directly or indirectly joined to the actuating element (10), and the connecting ends (46) of the legs (36, 38) are directly or indirectly joined to the retaining device (16), or vice versa.

6. The operating unit according to claim 5, **characterized in that** the free ends of the legs (36, 38) are held at a distance by a respective spacer element (40), and the connecting ends (46) of the legs (36, 38) are held at a distance by a further spacer element (48).

7. The operating unit according to claim 2 and 4 or according to any one of the preceding claims to the extent these have a dependency reference to claims 2 and 4, **characterized in that** a respective angular leaf spring pair (24, 26) is disposed at least in each of two diagonally opposed corner regions (28, 30) of the actuating element (10).

## Revendications

1. Unité de commande pour un composant de véhicule, en particulier un système de chauffage, de ventilation ou de climatisation, dotée
- d'un élément d'actionnement (10) actionnable manuellement,
- d'un dispositif de maintien (16) destiné à maintenir l'élément d'actionnement (10) et
- d'un dispositif de palier (18) destiné à la suspension élastique de l'élément d'actionnement (10) au dispositif de maintien (16),
- dans laquelle le dispositif de palier (18) comporte au moins une première paire de ressorts à lames (64) dotée de deux ressorts à lame (36) dotés respectivement d'une première extrémité et d'une deuxième extrémité opposée à celle-ci, agencés l'un au-dessus de l'autre et écartés l'un de l'autre et s'étendant parallèlement l'un à l'autre, dans laquelle les premières et les deuxièmes extrémités des ressorts à lames (36) sont reliées respectivement de manière rigide l'une à l'autre par un élément écarteur (40) et dans laquelle l'au moins une première paire de ressorts à lames (64) est reliée de manière rigide, directement ou indirectement, aux premières extrémités de ses ressorts à lames (36) à l'élément d'actionnement (10) et aux deuxièmes extrémités de ses ressorts à lames (36) au dispositif de maintien (16),
**caractérisée en ce que**
- le dispositif de palier (18) comporte au moins deux premières et au moins deux deuxièmes paires de ressorts à lames (64, 66) entre l'élément d'actionnement (10) et le dispositif de maintien (16), **en ce que**
- les premières paires de ressorts à lames (64) sont agencées en parallèle l'une en dessous de l'autre et les deuxièmes paires de ressorts à lames (66) sont agencées en parallèle l'une en dessous de l'autre et **en ce que**
- les premières paires de ressorts à lames (64) sont orientées de manière essentiellement orthogonale par rapport aux deuxièmes paires de ressorts à lames (66).

2. Unité de commande selon la revendication 1, **caractérisée en ce que** l'élément d'actionnement (10) est réalisé de manière rectangulaire avec quatre sections de bord (68, 70, 72, 74) sensiblement rectilignes, opposées par paires, et **en ce qu'**au moins deux premières et au moins deux deuxièmes paires de ressorts à lames (64, 66) sont agencées respectivement le long d'un des quatre bords de l'élément d'actionnement (10).

3. Unité de commande selon la revendication 1 ou 2, **caractérisée en ce que** les deux extrémités des ressorts à lames (36) de chaque paire de ressorts à lames (64, 66) respectivement agencées l'une au-dessus de l'autre sont maintenues écartées par le biais de l'élément écarteur (40) .

4. Unité de commande selon l'une des revendications 1 à 3, **caractérisée en ce qu'**une première et une deuxième paire de ressorts à lames (64, 66) sont réalisées comme paire de ressorts à lames coudée (24, 26) dotée de deux ressorts à lames (32, 34) formant un angle et en particulier formant un angle droit.

5. Unité de commande selon la revendication 3 ou 4, **caractérisée en ce que** chaque ressort à lames coudé (32, 34) comporte deux pattes (36, 38), **en ce que** chaque patte (36, 38) comporte une extrémité libre et une extrémité de liaison (46) reliée intégralement à l'autre patte respective (36, 38) et **en ce que** soit les extrémités libres des pattes (36, 38) sont reliées à l'élément d'actionnement (10) et les extrémités de liaison (46) des pattes (36, 38) sont reliées au dispositif de maintien (16), soit l'inverse, de manière directe ou indirecte.

6. Unité de commande selon la revendication 5, **caractérisée en ce que** les extrémités libres des pattes (36, 38) et les extrémités de liaison (46) des pattes (36, 38) sont maintenues écartées respectivement par le biais d'un élément écarteur (40) et d'un autre élément écarteur (48).

7. Unité de commande selon la revendication 2 et 4 ou selon l'une des revendications précédentes pour autant qu'elle renvoie aux revendications 2 et 4, **caractérisée en ce qu'**une paire de ressorts à lames coudée (24, 26) est respectivement agencée au moins dans chacune de deux zones d'angle (28, 30) opposées en diagonale de l'élément d'actionnement (10).
